(19) Europäisches Patentamt
European Patent Office
Office européen des brevets

(11) EP 4 586 326 A1

(12) **EUROPEAN PATENT APPLICATION**
published in accordance with Art. 153(4) EPC

(43) Date of publication:
16.07.2025 Bulletin 2025/29

(51) International Patent Classification (IPC):
*H01L 33/32* (2010.01)    *H01L 33/06* (2010.01)

(21) Application number: 23879844.1

(52) Cooperative Patent Classification (CPC):
**H10H 20/812; H10H 20/825**

(22) Date of filing: 18.10.2023

(86) International application number:
**PCT/JP2023/037781**

(87) International publication number:
**WO 2024/085201 (25.04.2024 Gazette 2024/17)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: 21.10.2022 JP 2022169198

(71) Applicant: Stanley Electric Co., Ltd.
Meguro-ku
Tokyo 153-8636 (JP)

(72) Inventors:
• **OBATA, Toshiyuki**
**Tokyo 153-8636 (JP)**
• **KINOSHITA, Toru**
**Tokyo 153-8636 (JP)**

(74) Representative: **Pritzlaff, Stefanie Lydia**
**Wagner & Geyer Partnerschaft mbB**
**Patent- und Rechtsanwälte**
**Gewürzmühlstraße 5**
**80538 München (DE)**

(54) **ULTRAVIOLET LIGHT-EMITTING SEMICONDUCTOR ELEMENT**

(57) An object is to provide an ultraviolet light-emitting semiconductor element having high efficiency, high output, reduced deterioration, and excellent element lifetime. Provided is an ultraviolet light-emitting semiconductor element including an n-type AlGaN layer, active layer, an $Al_{Y1}Ga_{1-Y1}N$ layer, and a p-type $Al_{Y2}Ga_{1-Y2}N$ layer ($Y2 \leq Y1$), in which the p-type $Al_{Y2}Ga_{1-Y2}N$ layer is co-doped with p-type and n-type impurities, a ratio of an n-type impurity concentration to a p-type impurity concentration satisfies $0.009 \leq (Nd/Na) < 0.185$, the $Al_{Y1}Ga_{1-Y1}N$ layer does not include the n-type impurity or a concentration of the n-type impurity is less than the concentration of the n-type impurity in the p-type $Al_{Y2}Ga_{1-Y2}N$ layer, the p-type $Al_{Y2}Ga_{1-Y2}N$ layer is a composition gradient layer where an Al composition decreases away from the $Al_{Y1}Ga_{1-Y1}N$ layer, the p-type $Al_{Y2}Ga_{1-Y2}N$ layer includes a high concentration region layer and a low concentration region layer of the n-type impurity, and the low concentration region layer is formed on at least any one interface side of the p-type $Al_{Y2}Ga_{1-Y2}N$ layer.

FIG.2B

EP 4 586 326 A1

## Description

Technical Field

The present invention relates to an ultraviolet light-emitting semiconductor element, in particular, a nitride semiconductor light-emitting element that emits ultraviolet light.

Background Art

Recently, a semiconductor light-emitting element having a deep ultraviolet range as an emission wavelength band has attracted as a light source having an inactivating action and a bactericidal effect for bacteria or viruses.

For example, Patent Literature 1 discloses an AlGaN-based semiconductor light-emitting element where a p-type semiconductor layer on an electron blocking layer is a composition gradient layer.

In addition, Patent Literatures 2 and 3 discloses a group III nitride semiconductor light-emitting element where an electron blocking layer is doped with Si and Mg.

In addition, Patent Literature 4 discloses a nitride semiconductor light-emitting element including an intermediate layer that is formed of a p-type AlGaN layer co-doped with an n-type dopant.

Citation List

Patent Literatures

Patent Literature 1: Japanese Patent Application Laid-Open No. 2019-160974
Patent Literature 2: Japanese Patent Application Laid-Open No. 2020-057783
Patent Literature 3: Japanese Patent Application Laid-Open No. 2019-083221
Patent Literature 4: Japanese Patent Application Laid-Open No. 2022-3660

Summary of Invention

Technical Problem

In the ultraviolet light-emitting semiconductor element in the related art, it is difficult to realize the element not only with high efficiency and high output but also with high reliability. In particular, there is a problem in that, when an element is driven at a high current to obtain a high light output, deterioration of the element progresses at an earlier stage as the emission wavelength decreases. That is, it is difficult to simultaneously achieve high output characteristics and high reliability (long lifetime).

The present inventors obtained findings regarding a trade-off relationship where, as the efficiency and output of an element increases, a decrease in output after current supply increases such that the element lifetime decreases, and a mechanism for the deterioration. The present invention has been made based on the above-described findings, and an object thereof is to provide an ultraviolet light-emitting semiconductor element having high efficiency, high output, reduced deterioration, and excellent element lifetime.

Solution to Problem

According to one embodiment of the present invention, there is provided an ultraviolet light-emitting semiconductor element including:

a semiconductor structure layer where an n-type AlGaN layer, an active layer, an $Al_{Y1}Ga_{1-Y1}N$ layer ($0.8 \leq Y1 \leq 1.0$), and a p-type $Al_{Y2}Ga_{1-Y2}N$ layer ($0.5 \leq Y2 \leq 1.0$, $Y2 \leq Y1$) are epitaxially grown in this order, in which the p-type $Al_{Y2}Ga_{1-Y2}N$ layer is co-doped with a p-type impurity as an acceptor and an n-type impurity as a donor, and a concentration ratio (Nd/Na) of a concentration (Nd) of the n-type impurity to a concentration (Na) of the p-type impurity satisfies $0.009 \leq (Nd/Na) < 0.185$,
the $Al_{Y1}Ga_{1-Y1}N$ layer does not include the n-type impurity or a concentration of the n-type impurity is less than the concentration of the n-type impurity in the p-type $Al_{Y2}Ga_{1-Y2}N$ layer,
the p-type $Al_{Y2}Ga_{1-Y2}N$ layer is a composition gradient layer where an Al composition Y2 decreases away from the $Al_{Y1}Ga_{1-Y1}N$ layer,
the p-type $Al_{Y2}Ga_{1-Y2}N$ layer includes a high concentration region layer where a concentration of the n-type impurity is high and a low concentration region layer where a concentration of the n-type impurity is low, and
the low concentration region layer is formed on at least any one interface side of the p-type $Al_{Y2}Ga_{1-Y2}N$ layer.

Brief Description of Drawings

FIG. 1 is a cross-sectional view schematically illustrating a structure of an ultraviolet light-emitting semiconductor element 10 according to one embodiment of the present invention.
FIG. 2A is a diagram schematically illustrating a band diagram of an ultraviolet LED 10.
FIG. 2B is an enlarged band diagram illustrating portions of an AlGaN layer 14 and a p-type AlGaN layer 15.
FIG. 3 is a table collectively illustrating characteristics of the ultraviolet LEDs 10 obtained from three types of wafers having different Mg concentrations in a p-type $Al_{Y2}Ga_{1-Y2}N$ layer 15.

FIG. 4A is a graph where a relationship between a Si concentration in the p-type $Al_{Y2}Ga_{1-Y2}N$ layer 15 and a luminous efficiency (arbitrary unit) of a current supply start initial stage is plotted.

FIG. 4B is a graph illustrating dependence of a forward voltage Vf on a layer thickness of a Si off region.

FIG. 4C is a graph illustrating dependence of the luminous efficiency on the layer thickness of the Si off region.

FIG. 5A is a graph where a relationship between a Si/Mg ratio (Si concentration/Mg concentration) of the p-type $Al_{Y2}Ga_{1-Y2}N$ layer 15 and the luminous efficiency (arbitrary unit) of the current supply start initial stage is plotted.

FIG. 5B is a graph illustrating an output retention (@100 h) after 100 hours were elapsed from the initial stage with respect to the Si concentration of the p-type $Al_{Y2}Ga_{1-Y2}N$ layer 15.

FIG. 5C is a graph illustrating the Si/Mg ratio (Si concentration/Mg concentration) of the p-type $Al_{Y2}Ga_{1-Y2}N$ layer 15 and the output retention.

FIG. 6 is a graph illustrating an output retention (@100 h) with respect to a light output (arbitrary unit) of the current supply start initial stage in elements obtained from structures 1 and 2 (EX1, EX2) and Comparative Examples 1 and 2 (CM1, CM2).

Description of Embodiments

Hereinafter, preferred examples of the present invention will be described, but these examples may be appropriately modified and combined. In addition, in the following description and the accompanying drawings, substantially the same or equivalent parts will be described with the same reference numerals.

[Structure of Ultraviolet Light-Emitting Semiconductor Element]

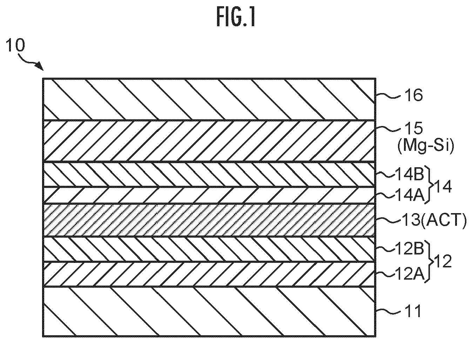

FIG. 1 is a cross-sectional view schematically illustrating a structure of an ultraviolet light-emitting semiconductor element 10 according to one embodiment of the present invention. The ultraviolet light-emitting semiconductor element 10 is an ultraviolet light-emitting diode (hereinafter, referred to as ultraviolet LED 10), in which an n-type AlGaN layer 12, an active layer 13, an AlGaN layer 14, a p-type AlGaN layer 15, and a p-type GaN layer 16 are sequentially stacked and formed by epitaxial growth on a substrate 11.

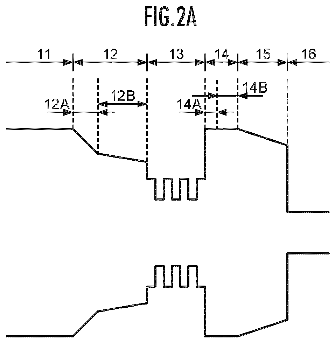

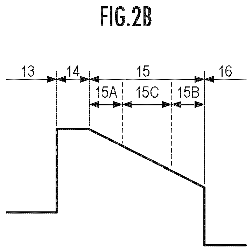

FIG. 2A is a diagram schematically illustrating a band diagram of the ultraviolet LED 10. FIG. 2B is an enlarged band diagram illustrating portions of the AlGaN layer 14 and the p-type AlGaN layer 15. The description will be given in more detail with reference to FIGS. 1, 2A, and 2B.

The substrate 11 is preferably a substrate having a low dislocation density such that the dislocation density in the active layer is low, but is not particularly limited thereto. A material with which the dislocation density in the active layer is adjusted to be $10^9$ cm$^{-2}$ or less and preferably $10^8$ cm$^{-2}$ or less is preferable. For example, an AlN template substrate where an AlN film is stacked on a sapphire substrate as described in Patent Literature 1, or a single-crystal AlN substrate described in Patent Literature 2 can be used.

When the AlN template substrate is used, it is preferable to select a substrate where the dislocation density on the outermost surface of the AlN layer is $10^9$ cm$^{-2}$ or less and more preferably $10^8$ cm$^{-2}$ or less. A growth method of the AlN layer in the template substrate is not particularly limited as long as the above-described dislocation density is satisfied. A metal organic chemical vapor deposition (MOCVD) method, a hydride vapor phase epitaxy (HVPE) method, or a physical vapor deposition method such as sputtering can be adopted.

In addition, a high surface roughness of the template substrate causes abnormal growth or the like of the AlGaN layer grown on the substrate. Therefore, the surface roughness (RMS) is preferably 1.0 nm or less and more preferably 0.5 nm or less. In addition, in order to obtain this surface roughness or to remove a damage layer formed on the surface after the growth, the surface of the template substrate may be polished by a well-known polishing method such as chemical mechanical polishing (CMP). In addition, a superlattice layer for interference of distortions with the n-type AlGaN layer can also be further provided on the AlN template substrate.

In addition, from the viewpoint of reducing the dislocation density in the active layer, it is preferable to use the single-crystal AlN substrate as the substrate 11. The dislocation density in the single-crystal AlN substrate is preferably $10^8$ cm$^{-2}$ or less, more preferably $10^6$ cm$^{-2}$ or less, and most preferably $10^4$ cm$^{-2}$ or less. By using the AlN substrate having a lower dislocation density of $10^6$ cm$^{-2}$ or less or $10^4$ cm$^{-2}$, a decrease in the luminous efficiency of the active layer caused by dislocation can be prevented. Further, defects such as diffusion of impurity through dislocation occurring during current supply to the ultraviolet light-emitting element or an increase in leakage current can be prevented.

In addition, due to the same reason as that of the above-described AlN template substrate, the surface roughness (RMS) of the single-crystal AlN substrate 11 is preferably 1.0 nm or less and more preferably 0.5 nm or less. Of course, the surface of the AlN substrate may be polished by a well-known polishing method such as chemical mechanical polishing (CMP).

In addition, when an absorption coefficient of the substrate with respect to ultraviolet light emitted from the active layer is high, the total amount of ultraviolet light extracted to the outside decreases, which may lead to a decrease in luminous efficiency. Therefore, the absorption coefficient of the AlN layer in the AlN substrate and the AlN template is preferably 20 cm$^{-1}$ or less and more

preferably 10 cm$^{-1}$ or less. By adjusting the absorption coefficient to be 10 cm$^{-1}$ or less, for example, even when the sheet thickness of the AlN substrate 11 is 100 $\mu$m, a linear transmittance of 90% or more can be ensured.

The n-type AlGaN layer 12 is an n-type conductive layer doped with silicon (Si). The Al composition in the n-type AlGaN layer can be appropriately determined such that sufficient transmittivity for a desired emission wavelength of ultraviolet light can be obtained. In the ultraviolet light-emitting semiconductor element, ultraviolet light emitted from an emission layer transmits through the n-type AlGaN layer 12 and the substrate 11 and is emitted to the outside. In addition, the reason for this is as follows. As the Al composition of the n-type AlGaN layer increases, a bandgap of the n-type AlGaN layer increases. Accordingly, transmission of ultraviolet light having a shorter wavelength can be allowed.

In addition, the n-type AlGaN layer 12 may be formed of a plurality of layers having different Al compositions, or can also be a composition gradient layer where there is a gradient of the Al composition in a stacking direction. For example, the n-type AlGaN layer 12 may be formed of a first n-type $Al_{X1}Ga_{1-X1}N$ layer 12A and a second n-type $Al_{X2}Ga_{1-X2}N$ layer 12B. The first n-type $Al_{X1}Ga_{1-X1}N$ layer 12A can be made to be a composition gradient layer where the Al composition X1 decreases from 1.0 to 0.75 in the stacking direction, and the second n-type $Al_{X2}Ga_{1-X2}N$ layer 12B can be made to be a composition gradient layer where the Al composition X2 decreases from 0.75 to 0.70.

In addition, the film thickness of the n-type AlGaN layer 12 is not particularly limited and is appropriately determined. When the single-crystal AlN substrate is used as the substrate 11, the film thickness of the n-type AlGaN layer 12 is preferably 0.5 $\mu$m or more and 2 $\mu$m or less. The reason for this is as follows. From the viewpoint of reducing a resistance value of the n-type AlGaN layer, the film thickness of the n-type AlGaN layer is preferably large. In a case where the AlN substrate is used as the substrate 11, when the film thickness of the n-type AlGaN layer is excessively large, the n-type AlGaN layer is likely to cause lattice relaxation to occur, and dislocation is likely to occur.

For example, when the n-type AlGaN layer 12 is formed as a stacking structure consisting of the first n-type $Al_{X1}Ga_{1-X1}N$ layer 12A and the second n-type $Al_{X2}Ga_{1-X2}N$ layer 12B described above, the first n-type $Al_{X1}Ga_{1-X1}N$ layer 12A has a layer thickness of 200 nm, and the second n-type $Al_{X2}Ga_{1-X2}N$ layer 12B has a layer thickness of 1000 nm. In addition, the film thicknesses of the first n-type $Al_{X1}Ga_{1-X1}N$ layer 12A and the second n-type $Al_{X2}Ga_{1-X2}N$ layer 12B are not limited to exemplary numerical values, and can be appropriately determined such that the total film thickness is 2.0 $\mu$m or less.

On the other hand, when the AlN template substrate is used, the film thickness of the n-type AlGaN layer 12 is preferably 1.5 $\mu$m or more and 10 $\mu$m or less.

By increasing the film thickness of the n-type AlGaN layer 12, an effect of reducing not only the resistance value but also the dislocation can also be expected. Therefore, it is considered that the film thickness is preferably 1.5 $\mu$m or more. In addition, it is considered that, when the AlN template substrate is used, the upper limit of the film thickness of the n-type AlGaN layer 12 is preferably about 10.0 $\mu$m from the industrial viewpoint of a manufacturing time or the like.

In addition, the concentration of Si with which the n-type AlGaN layer 12 is doped may be appropriately determined to obtain desired n-type conductivity. From the viewpoint of reducing the resistance value of the n-type AlGaN layer 12, the Si concentration is preferably 1 x 10$^{18}$ to 1 x 10$^{20}$ cm$^{-3}$ and more preferably 5 x 10$^{18}$ to 5 x 10$^{19}$ cm$^{-3}$. In addition, the Si doping concentration may be fixed in a film thickness direction in the n-type AlGaN layer, and modulation doping where the Si concentration varies in the film thickness direction can also be performed.

The Si concentration and a Mg concentration described below can be measured by well-known secondary ion mass spectrometry (SIMS). In addition, as the measured values of the Si concentration and the Mg concentration in the present application, quantitative values using standard samples of AlN, $Al_{0.65}Ga_{0.35}N$, and GaN are adopted for the AlN layer, the AlGaN layer, and the GaN layer, respectively.

The active layer (ACT) 13 has a quantum well structure including a barrier layer formed of an $Al_{A1}Ga_{1-A1}N$ layer and a well layer formed an $Al_{A2}Ga_{1-A2}N$ layer. An emission peak wavelength of the active layer 13 is in a range of 210 to 300 nm. Since the wavelength of light emitted from the active layer 13 is determined depending on the film thickness of the Al composition of the well layer, the Al composition and the film thickness can be appropriately determined to obtain a desired emission wavelength in the above-described wavelength range. The reliability of the ultraviolet light-emitting element has wavelength dependence, and generally, as the emission wavelength decreases, the element lifetime decreases. Accordingly, in the present invention, it is considered that, as the emission wavelength decreases, the effect becomes more significant. The wavelength range is preferably 210 to 300 nm and more preferably 210 to 270 nm.

For example, the film thickness of the well layer is set in a range of 2 to 10 nm, and the Al composition can be determined to obtain a desired emission wavelength. In addition, the Al composition and the film thickness of the barrier layer are not particularly limited. For example, the Al composition can be set to satisfy A2 < A1 $\leq$ 1.0, and the film thickness can be set in a range of 2 to 15 nm.

In addition, the well layer or the barrier layer can also be formed as an n-type layer doped with Si. Both of the well layer and the barrier layer may be Si doping layers, or only the well layer or only the barrier layer may have a structure doped with Si. The concentration of Si to be doped is not particularly limited and is preferably in a

range of $1 \times 10^{17}$ to $5 \times 10^{18}$ cm$^{-3}$.

In addition, the number of layers in the quantum well is not particularly limited, and a multi quantum well (MQW) structure formed of a plurality of well layers or a single quantum well (SQW) may be adopted. It is preferable that the number of well layers is appropriately determined in a range of 1 to 5.

The $Al_{Y1}Ga_{1-Y1}N$ layer 14 is a layer provided adjacent to the active layer 13. The $Al_{Y1}Ga_{1-Y1}N$ layer 14 functions as an electron blocking layer (EBL) for suppressing the overflow of electrons injected into the active layer 13 to a p-type $Al_{Y2}Ga_{1-Y2}N$ layer 15. Therefore, the $Al_{Y1}Ga_{1-Y1}N$ layer 14 has a larger bandgap than the active layer 13 and the p-type $Al_{Y2}Ga_{1-Y2}N$ layer 15 described below, and the Al composition Y1 of the $Al_{Y1-}Ga_{1-Y1}N$ layer 14 is determined in a range of $0.8 < Y1 \leq 1.0$.

As the wavelength of the emission wavelength decreases, the Al composition of the AlGaN layer that is epitaxially grown on the substrate 11 increases, and when the emission wavelength is shorter than 270 nm, in order to sufficiently exhibit the function as the electron blocking layer, the Al composition Y1 is preferably $0.9 \leq Y1 \leq 1.0$. In the present example, AlN (Y1 = 1) is used as the $Al_{Y1}Ga_{1-Y1}N$ layer 14.

In addition, as long as the function as the electron blocking layer can be exhibited, the $Al_{Y1}Ga_{1-Y1}N$ layer 14 may be an undoped layer or may be doped with a p-type dopant. As the p-type dopant material in the $Al_{Y1}Ga_{1-Y1}N$ layer 14, magnesium (Mg), zinc (Zn), beryllium (Be), carbon (C), or the like can be used. In particular, as the p-type dopant material of the AlGaN layer, Mg that is generally used is preferably used. Even in examples of the present invention described below, Mg is used.

The p-type dopant material may be uniformly doped in the stacking direction of the $Al_{Y1}Ga_{1-Y1}N$ layer 14, or the concentration of the dopant material can also change in the stacking direction. For example, a stacking structure consisting of an undoped AlN layer 14A (Y1 = 1) and a magnesium (Mg)-doped p-type AlN layer 14B from a side in contact with the active layer can also be adopted.

A p-type dopant concentration in the $Al_{Y1}Ga_{1-Y1}N$ layer 14 is not particularly limited, and is preferably $5 \times 10^{18}$ to $1 \times 10^{20}$ cm$^{-3}$ to obtain the function as the electron blocking layer and more preferably $1 \times 10^{19}$ to $8 \times 10^{19}$ cm$^{-3}$ from the viewpoint of improving the injection efficiency of carriers into the emission layer.

The $Al_{Y1}Ga_{1-Y1}N$ layer 14 according to the present invention does not include an n-type dopant, or can include the n-type dopant at a concentration less than that of the n-type dopant in the p-type $Al_{Y2}Ga_{1-Y2}N$ layer 15 described below. Specifically, an n-type impurity concentration in the $Al_{Y1}Ga_{1-Y1}N$ layer 14 is preferably $1 \times 10^{18}$ cm$^{-3}$ or less. According to the findings by the present inventors, it is known that diffusion of the dopant occurs between the $Al_{Y1}Ga_{1-Y1}N$ layers 14 adjacent to each other during the growth of the p-type $Al_{Y2}Ga_{1-Y2}N$ layer 15. Therefore, when the n-type dopant concentration in the $Al_{Y1}Ga_{1-Y1}N$ layer 14 is higher than the p-type $Al_{Y2-}Ga_{1-Y2}N$ layer 15, the n-type dopant is diffused from the $Al_{Y1}Ga_{1-Y1}N$ layer 14 to the p-type $Al_{Y2}Ga_{1-Y2}N$ layer 15, and it may be difficult to precisely control the n-type dopant concentration in the p-type $Al_{Y2}Ga_{1-Y2}N$ layer 15. In order to prevent a change in the concentration of the n-type dopant in the p-type $Al_{Y2}Ga_{1-Y2}N$ layer 15 caused by the diffusion, at least the n-type dopant in the $Al_{Y1}Ga_{1-Y1}N$ layer 14 needs to be less than the following concentration of the n-type dopant in the p-type $Al_{Y2}Ga_{1-Y2}N$ layer 15.

In addition, the film thickness of the $Al_{Y1}Ga_{1-Y1}N$ layer 14 may be appropriately determined such that the function as the electron blocking layer can be exhibited and holes can be efficiently injected from the p-type $Al_{Y2}Ga_{1-Y2}N$ layer 15 to the active layer, and is preferably in a range of 1 to 30 nm. When the film thickness falls below 1 nm, the function as the electron blocking layer decreases due to tunneling of electrons. On the other hand, when the film thickness exceeds 30 nm, holes are not likely to be injected from the p-type $Al_{Y2}Ga_{1-Y2}N$ layer 15 into the active layer. In consideration of the fact, the film thickness of the $Al_{Y1}Ga_{1-Y1}N$ layer 14 is preferably 2 to 20 nm and more preferably 5 to 15 nm.

In addition, as described above, Mg to be doped in the $Al_{Y1}Ga_{1-Y1}N$ layer 14 can also provide a difference in concentration in the stacking direction. For example, a structure in which the undoped AlN layer 14A having a layer thickness of 1 to 5 nm is stacked on the side in contact with the active layer 13 and the Mg-doped p-type AlN layer 14B having a layer thickness of 5 to 15 nm is stacked can also be adopted. At this time, as described above, the Mg doping concentration is preferably $5 \times 10^{18}$ to $1 \times 10^{20}$ cm$^{-3}$ and more preferably $1 \times 10^{19}$ to $8 \times 10^{19}$ cm$^{-3}$.

The p-type $Al_{Y2}Ga_{1-Y2}N$ layer 15 according to the present invention is formed on the $Al_{Y1}Ga_{1-Y1}N$ layer 14 and functions as a p-type cladding layer. The p-type $Al_{Y2}Ga_{1-Y2}N$ layer 15 is co-doped with a p-type impurity as an acceptor and an n-type impurity as a donor.

As the p-type impurity with which the p-type $Al_{Y2}Ga_{1-Y2}N$ layer 15 is doped, magnesium (Mg), zinc (Zn), beryllium (Be), carbon (C), or the like can be used. In particular, Mg that is generally used as a p-type dopant material of an AlGaN semiconductor is preferably used. In addition, as the n-type impurity, Si, germanium (Ge), selenium (Se), sulfur (S), oxygen (O), or the like can be used. In particular, Si that is generally used as an n-type dopant material is preferably used.

In the p-type $Al_{Y2}Ga_{1-Y2}N$ layer 15 according to the present invention, a ratio (Nd/Na) between the n-type impurity concentration (Nd) and the p-type impurity concentration in the p-type $Al_{Y2}Ga_{1-Y2}N$ layer 15 satisfies Formula (1).

$$0.009 \leq (Nd/Na) < 0.185 \ ... \ \text{Formula (1)}$$

Further, it is more preferable that Nd/Na satisfies any one of the following formulae.

$$0.009 \leq (Nd/Na) < 0.135 \ldots \text{Formula (2)}$$

$$0.038 \leq (Nd/Na) < 0.185 \ldots \text{Formula (3)}$$

By co-doping the p-type $Al_{Y2}Ga_{1-Y2}N$ layer 15 such that Nd/Na satisfies any one of Formulae (1) to (3), an ultraviolet LED having a high luminous efficiency and a favorable output retention (element lifetime) is realized.

In addition, the amount of the p-type impurity with which the p-type $Al_{Y2}Ga_{1-Y2}N$ layer 15 is doped is preferably 1 x $10^{17}$ to 1.2 x $10^{20}$ cm$^{-3}$. In addition, as theoretically shown in J. Applmaru Physmaru, Volmaru 95, No. 8, 15 April (2004), it is considered that the amount of nitrogen defects causing deterioration increases along with the amount of the p-type impurity in the p-type $Al_{Y2}Ga_{1-Y2}N$ layer 15. Therefore, when the amount of the p-type impurity exceeds 1.2 x $10^{20}$ cm$^{-3}$, the amount of nitrogen defects formed at an initial stage is excessively large, and it is difficult to obtain a high output retention.

In addition, in a case where the p-type impurity concentration is low, particularly when the Al composition Y2 is fixed, the output decreases due to a decrease in hole concentration and an increase in minority carrier (electron) mobility, and when there is a gradient of the Al composition Y2, the output decreases due to an increase in minority carrier (electron) mobility. Therefore, it is difficult to obtain a high luminous efficiency. Accordingly, the p-type impurity concentration can be appropriately determined in the above-described range in consideration of the above-described trade-off. In order to obtain a higher output retention and a high output, the p-type impurity concentration is preferably 1 x $10^{19}$ to 5 x $10^{19}$ cm$^{-3}$ and more preferably 1 x $10^{19}$ to 4 x $10^{19}$ cm$^{-3}$.

In the ultraviolet light-emitting semiconductor element 10 according to the present embodiment, the p-type $Al_{Y2}Ga_{1-Y2}N$ layer 15 is a composition gradient layer where the Al composition Y2 decreases in the stacking direction, that is, away from an interface with the $Al_{Y1}Ga_{1-Y1}N$ layer 14 adjacent thereto.

The p-type $Al_{Y2}Ga_{1-Y2}N$ layer 15 is preferably a composition gradient layer where the Al composition Y2 decreases linearly in the direction away from the interface with the $Al_{Y1}Ga_{1-Y1}N$ layer 14. However, the present invention is not limited thereto, and the p-type $Al_{Y2}Ga_{1-Y2}N$ layer 15 may be a composition gradient layer where the Al composition decreases in a curved manner. Alternatively, the Al composition may decrease stepwise, or these configurations may be combined.

The amount of the n-type impurity with which the p-type $Al_{Y2}Ga_{1-Y2}N$ layer 15 is doped is preferably 1.1 x $10^{18}$ or more and 9.0 x $10^{18}$ cm$^{-3}$ or less and more preferably 1.8 x $10^{18}$ or more and 8.0 x $10^{18}$ cm$^{-3}$ or less. With the amount of the n-type impurity, the light-emitting semiconductor element 10 having a high luminous efficiency can be obtained.

In addition, the concentrations of the p-type impurity and the n-type impurity with which the p-type $Al_{Y2}Ga_{1-Y2}N$ layer 15 is doped may be fixed in the layer or may have a difference in concentration in the stacking direction. Note that, in order to drive the element at a higher output and a low voltage, in both of interface portions of the p-type $Al_{Y2}Ga_{1-Y2}N$ layer 15, it is preferable that the n-type impurity is not added, or the concentration of the n-type impurity is low.

The depletion of the interface portions is suppressed by the partially limited n-type impurity doping on the p-type $Al_{Y2}Ga_{1-Y2}N$ layer 15 such that an increase in voltage is suppressed. In addition, the n-type impurity doping also contributes to a decrease in minority carrier (electron) mobility, and thus a higher output than that of no n-type impurity doping can be obtained. Accordingly, when a higher wall plug efficiency (WPE) than that of no n-type impurity doping is desired, it is preferable that the n-type impurity concentration at least in the vicinity of the interface between the $Al_{Y1}Ga_{1-Y1}N$ layer 14 and the p-type $Al_{Y2}Ga_{1-Y2}N$ layer 15 is low. The reason for this is as follows. Since the p-type $Al_{Y2}Ga_{1-Y2}N$ layer 15 is the composition gradient layer, the depletion layer width formed in the interface with the $Al_{Y1}Ga_{1-Y1}N$ layer 14 is wider than that in the interface with the p-type GaN layer 16. Therefore, the effect of no n-type impurity doping is high.

The Al composition Y2 of the p-type $Al_{Y2}Ga_{1-Y2}N$ layer 15 is 0.5 or more and 1.0 or less and is less than or equal to the Al composition Y1 of the $Al_{Y1}Ga_{1-Y1}N$ layer 14.

In a structure where Y2 is a fixed value in the stacking direction, it is preferable that the Al composition Y2 of the p-type $Al_{Y2}Ga_{1-Y2}N$ layer 15 exceeds the Al composition of the barrier layer of the active layer and is less than or equal to the Al composition Y1 of the $Al_{Y1}Ga_{1-Y1}N$ layer 14. By adjusting the Al composition Y2 of the p-type $Al_{Y2}Ga_{1-Y2}N$ layer 15 to be in the above-described range, even when an injection current amount of the ultraviolet light-emitting element is high, a high effect of suppressing the carrier overflow can be obtained. In order to obtain a higher effect, it is preferable that a difference between the Al composition of the well layer of the active layer and the Al composition Y2 of the p-type $Al_{Y2}Ga_{1-Y2}N$ layer 15 is 0 or more, and it is more preferable that a difference between the Al composition of the barrier layer and the Al composition Y2 of the p-type $Al_{Y2}Ga_{1-Y2}N$ layer 15 is 0 or more. In addition, it is preferable that the Al composition Y2 of the p-type $Al_{Y2}Ga_{1-Y2}N$ layer 15 is more than the Al composition of the n-type AlGaN layer 12. As a result, the effect of suppressing the carrier overflow to the p-type layer can be improved, and the luminous efficiency of the ultraviolet light-emitting element can be improved. From the above, in a structure where Y2 is a fixed value in the stacking direction, the Al composition Y2 of the p-type $Al_{Y2}Ga_{1-Y2}N$ layer 15 is preferably 0.6 or more and 0.9 or less.

In addition, the p-type $Al_{Y2}Ga_{1-Y2}N$ layer 15 may be a composition gradient layer where the Al composition Y2 changes in the stacking direction. In particular, a structure where the Al composition Y2 decreases in the stacking direction from a side in contact with the $Al_{Y1}Ga_{1-Y1}N$ layer 14 is preferable. As a result, the polarization doping effect can be obtained in the p-type $Al_{Y2}Ga_{1-Y2}N$ layer 15. Therefore, a higher hole concentration is likely to be obtained, and thus the injection efficiency of holes into the active layer increases. For example, when the emission wavelength is 270 nm or less, the Al composition on the side in contact with the $Al_{Y1}Ga_{1-Y1}N$ layer 14 is preferably 0.85 to 1.0 and more preferably 0.9 to 1.0. At this time, a relationship of $Y1 \geq Y2$ is satisfied. The Al composition on a surface layer of the p-type $Al_{Y2}Ga_{1-Y2}N$ layer 15 on the opposite side (that is, a side in contact with the p-type GaN layer 16) is preferably 0.5 to 0.85 and more preferably 0.6 to 0.85. By adopting this structure, the above-described polarization doping effect can be improved, and the transparency with respect to the emission wavelength can be maintained. Therefore, a high luminous efficiency is likely to be obtained.

In addition, the film thickness of the p-type $Al_{Y2}Ga_{1-Y2}N$ layer 15 is not particularly limited and may be appropriately determined in a range of 10 to 150 nm. When the film thickness of the p-type $Al_{Y2}Ga_{1-Y2}N$ layer 15 is less than 10 nm, the above-described effect of suppressing the carrier overflow is not likely to be obtained. On the other hand, when the film thickness increases and exceeds 150 nm, the resistance value of the p-type $Al_{Y2}Ga_{1-Y2}N$ layer 15 increases, which leads to an increase in the operating voltage of the ultraviolet light-emitting element. From this viewpoint, the film thickness of the p-type $Al_{Y2}Ga_{1-Y2}N$ layer 15 is preferably 40 to 120 nm and more preferably 50 to 100 nm.

In order to decrease a contact resistance with an electrode, the p-type GaN layer 16 doped with a p-type dopant may be formed on the p-type $Al_{Y2}Ga_{1-Y2}N$ layer 15. As the p-type dopant material, the above-described well-known p-type dopant material can be used, and Mg is preferably used due to the same reason. The Mg doping concentration of the p-type GaN layer 16 is not particularly limited and, in order to reduce the resistance value in the p-type GaN layer and reduce the contact resistance with an electrode, is preferably $1 \times 10^{18}$ to $2 \times 10^{20}$ cm$^{-3}$. In addition, the film thickness of the p-type GaN layer 16 is not particularly limited and may be appropriately determined in a range of 5 to 500 nm.

When AlN is used as the substrate 11, in all of the layers including the AlGaN layers 12, 13, 14, and 15 excluding the p-type GaN layer 16, crystals are grown in a state of lattice junction with the AlN substrate 11. Therefore, the AlGaN layers 12, 13, 14, and 15 have a low dislocation density as in the AlN substrate 11. Specifically, the AlGaN layers 12, 13, 14, and 15 have a dislocation density of $10^5$ cm$^{-2}$ or less.

The case where the ultraviolet light-emitting semiconductor element 10 is a light-emitting diode (LED) has been described. However, the ultraviolet light-emitting semiconductor element 10 may be configured as a semiconductor laser element (LD: Laser Diode).

The semiconductor light-emitting element including the substrate 11 has been described as the ultraviolet light-emitting semiconductor element 10. However, in consideration of the properties and the like of the substrate to be used, the substrate 11 can also be removed as necessary, and can be optionally included.

The semiconductor light-emitting element including the substrate 11 on the n-type AlGaN layer 12 side has been described as the ultraviolet light-emitting semiconductor element 10. Another support substrate different from the substrate 11 used for the epitaxial growth can also be provided on the p-type GaN layer 16 side. In this case, a material or the like of the support substrate is not particularly limited, and a well-known material such as polycrystalline AlN, Si, $Al_2O_3Cu$, or CuW that is used as a support substrate member of a light-emitting element can be used without limitation.

Hereinafter, as the ultraviolet light-emitting semiconductor element 10, a semiconductor light-emitting element including the substrate 11 as the substrate for the growth of the semiconductor stacking structure will be described. As described above, a semiconductor light-emitting element including the substrate 11 such as the support substrate different from the substrate for the growth can also be used.

Next, a method of manufacturing the ultraviolet LED having the above-described structure will be described. The ultraviolet LED 10 according to the present invention can be manufactured by a well-known crystal growth method such as an MOCVD method or a molecular-beam epitaxy (MBE) method. In particular, an MOCVD method that has high productivity and is industrially widely adopted is preferable. As the group III (Al, Ga) raw material gas or the group V (N) raw material gas used in the present invention, well-known raw material gas can be used without any particular limitation.

For example, as the group III raw material gas, gas such as trimethylaluminum, triethylaluminum, trimethylgallium, or triethylgallium can be used. In addition, as the group V raw material gas, typically, ammonia is used.

In addition, as the dopant raw material gas of Mg and Si, a well-known material can be used without limitation. For example, biscyclopentadienyl magnesium, monosilane, or tetraethylsilane can be used.

By supplying the above-described raw material gases to the substrate 11 together with carrier gas such as hydrogen and/or nitrogen, the element layers of the ultraviolet LED 10 are grown.

A supply amount ratio (V/III ratio) between group III raw material gas and the group V raw material gas may be appropriately determined to obtain desired characteristics, and is preferably set in a range of 500 to 10000.

In addition, a growth temperature of the element layers forming the ultraviolet LED 10 is not particularly limited and may be appropriately determined to obtain desired characteristics of each of the layers and desired characteristics of the ultraviolet LED 10. The growth temperature is preferably 1000 to 1200°C and more preferably 1000 to 1150°C. Examples

Hereinafter, the present invention will be described in detail using Examples of preparing ultraviolet LEDs having an emission wavelength of 265 nm. However, the present invention is not limited to these examples.

[Preparation of Element]

As a substrate for growth of the ultraviolet LED element layer, a single-crystal AlN substrate prepared using a method described in Applied Physics Express 5 (2012) 122101 was used. Specifically, a stacked substrate including a C-plane AlN seed substrate prepared by a physical vapor transport (PVT) method and an AlN thick film grown by an HVPE method is used. The dislocation density of the AlN substrate was $10^5$ cm$^{-2}$ or less, and the surface roughness (RMS) in a range of 5 x 5 $\mu$m$^2$ was 0.1 nm.

Using an MOCVD device, an AlN layer (100 nm), a first n-type AlGaN layer 12A (200 nm), and a second n-type AlGaN layer 12B (1000 nm) were grown on the AlN substrate. Both of the first n-type AlGaN layer 12A and the second n-type AlGaN layer 12B were composition gradient layers. In the first n-type AlGaN layer 12A, the Al composition on a side in contact with the AlN layer decreased from 1.0 to 0.75. In the second n-type AlGaN layer 12B, the Al composition on a side in contact with the first n-type AlGaN layer 12A decreased from 0.75 to 0.70. In addition, the Si concentration in the n-type AlGaN layer 12 is controlled to be 1 x $10^{19}$ cm$^{-3}$.

Next, the active layer 13 formed of three multiple quantum well layers including a barrier layer formed of n-type $Al_{0.6}Ga_{0.4}N$ (7 nm) and a well layer formed of $Al_{0.5}Ga_{0.5}N$ (4 nm) were grown. The Si concentration of the barrier layer was controlled to be 1 x $10^{18}$ cm$^{-3}$.

Next, an electron blocking layer 14 formed of AlN (10 nm) was grown. The electron blocking layer on a side in contact with the barrier layer was an undoped layer 14A (2 nm), and the remaining electron blocking layer 14B was a Mg-doped layer of 4 x $10^{19}$ cm$^{-3}$. The undoped AlN layer 14A and the Mg-doped p-type AlN layer 14B were not doped with Si.

Next, a p-type AlGaN layer 15 (60 nm) was grown. The p-type AlGaN layer 15 was a composition gradient layer where the Al composition on a side in contact with the electron blocking layer decreased from 1.0 to 0.8. A wafer (hereinafter, referred to as a structure 1 (EX1)) where the Mg concentration in the p-type AlGaNlayer 15 was 1.0 x $10^{20}$ cm$^{-3}$ (hereinafter also referred to as 1.0E20 cm$^{-3}$) and a wafer (hereinafter, referred to as a structure 2 (EX2)) where the Mg concentration in the p-type AlGaN layer 15 was 4.3E19 cm$^{-3}$ were prepared.

Further, a wafer having a structure 3 (EX3) having the same structure as the structure 2 (EX2) except that the p-type AlGaN layer 15 had a low concentration region layer of n-type impurity (hereinafter, also referred to as a co-doped off region or an off region) was prepared.

More specifically, as illustrated in FIG. 2B, in the structure 3 (EX3), the p-type $Al_{Y2}Ga_{1-Y2}N$ layer 15 includes low concentration region layers 15A and 15B where the concentration of n-type impurity was lower than that of a center region (high concentration region layer 15C) on the interface side with the $Al_{Y1}Ga_{1-Y1}N$ layer 14 and the interface side with the p-type GaN layer 16.

In addition, in each of the structures, a plurality of wafers where the concentration of Si to be co-doped was adjusted in a range of 1 x $10^{18}$ to 9 x $10^{18}$ cm$^{-3}$ were prepared.

When the n-type impurity concentration in the vicinity of the interface of the p-type $Al_{Y2}Ga_{1-Y2}N$ layer 15 was decreased for a high WPE, the thickness of the low concentration region layers 15A and 15B is preferably 2 nm or more, more preferably 4 nm or more, and still more preferably 8 nm or more. In addition, the thickness of the low concentration region layers 15A and 15B is preferably 30% or less and more preferably 20% or less of the thickness of the p-type $Al_{Y2}Ga_{1-Y2}N$ layer 15.

In addition, the concentration in the low concentration region layers 15A and 15B is less than that in the high concentration region layer 15C more preferably 1/2 or less and more preferably 1/10 or less.

An example where the p-type $Al_{Y2}Ga_{1-Y2}N$ layer 15 includes the low concentration region layers 15A and 15B on both of the interface sides, respectively will be described. However, only one of the low concentration region layers 15A and 15B may be provided. In this case, it is preferable that low concentration region layer 15A is provided on the interface side with the $Al_{Y1}Ga_{1-Y1}N$ layer 14.

Next, a p-type GaN layer 16 (270 nm) was grown, and a deep ultraviolet LED element layer was completed. The Mg concentration in the p-type GaN layer 16 was 5 x $10^{19}$ cm$^{-3}$.

Next, etching was performed by inductively coupled plasma (ICP) dry etching until the second n-type AlGaN layer was exposed, an n-type electrode where a Ti layer and an Au layer were stacked was formed, and a heat treatment was performed in a nitrogen atmosphere under a condition of 900°C. Next, a p electrode where an Ni layer and an Au layer were stacked was formed on the p-type GaN layer, and a heat treatment was performed in an oxygen atmosphere under a condition of 500°C.

Next, a back surface (opposite to the ultraviolet LED element layer) of the substrate for the growth was mechanically polished until the AlN thick film formed by the HVPE method was exposed, and an ultraviolet LED was completed. Next, the wafer was cut by dicing into chips having a size of 0.75 mm x 0.95 mm, the chip was subjected to flip chip bonding on the ceramic submount to complete an ultraviolet LED element.

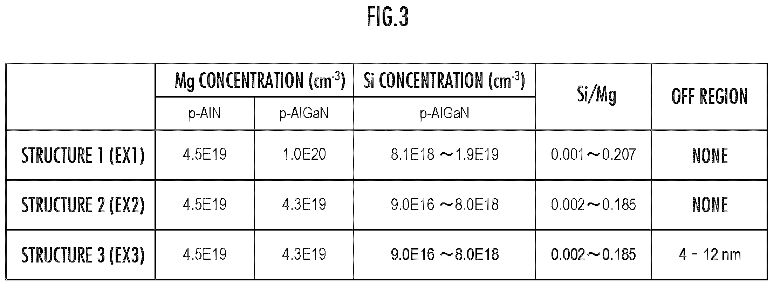

FIG. 3 is a table collectively showing the Mg concentration, the Si concentration, the ratio (Si/Mg) between the Si concentration and the Mg concentration, and whether the off region was provided in the p-type AlN layers 14 and the p-type AlGaN layers 15 of the structure 1 (EX1), the structure 2 (EX2), and the structure 3 (EX3) according to the present embodiment.

In addition, in Comparative Example 1 and Comparative Example 2 (hereinafter, referred to as CM1 and CM2) for comparison to the structure 1 (EX1), the structure 2 (EX2), and the structure 3 (EX3), a wafer that was not co-doped with Si was prepared. In the wafers according to CM1 and CM2, the Mg concentrations in the p-type AlGaN layers 15 were $1.0E20$ cm$^{-3}$ and $4.3E19$ cm$^{-3}$, respectively, which were the same as the wafers of the structure 1 (EX1) and the structure 2 (EX2).

In the non-co-doped structures of Comparative Examples, Si was incorporated, Si of about $7 \times 10^{16}$ to $1 \times 10^{17}$ cm$^{-3}$ was detected by SIMS (Secondary Ion Mass Spectrometry) measurement but was the detection lower limit in the SIMS analysis, which was lower than the actual concentration. That is, the measured value of about $7 \times 10^{16}$ to $1 \times 10^{17}$ cm$^{-3}$ represents that a concentration of $7 \times 10^{16}$ to $1 \times 10^{17}$ cm$^{-3}$ or higher was not included.

[Evaluation of Element]

The Mg concentration, the Si concentration, and the luminescence properties of the various ultraviolet LEDs 10 described above were evaluated. The Mg concentration and the Si concentration were measured by SIMS for each of the elements. For quantification of the AlN layer and the AlGaN layer, AlN and $Al_{0.65}Ga_{0.35}N$ were used as standard samples, respectively.

(1) luminous Efficiency of Initial Stage

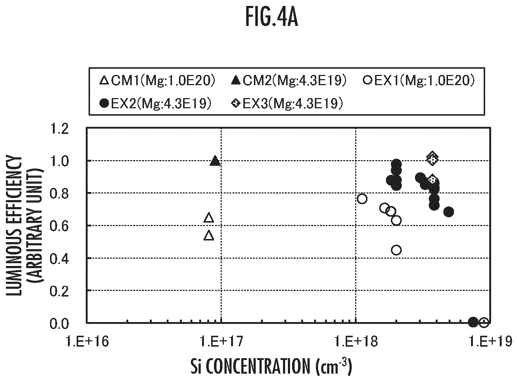

FIG. 4A is a graph where a relationship between the Si concentration in the p-type $Al_{Y2}Ga_{1-Y2}N$ layer 15 (hereinafter, also referred to as the p-type cladding layer 15) and the luminous efficiency (arbitrary unit) of the current supply start initial stage is plotted.

In both of the structure 1 (EX1) and the structure 2 (EX2), by co-doping Si, the luminous efficiency of the initial stage did not substantially change, or tended to be slightly decreased. However, in the structure 1, when the Si concentration was increased up to $8E18$ cm$^{-3}$, the luminous efficiency was rapidly decreased. In the structure 2, when the Si concentration was increased up to $9E18$ cm$^{-3}$, the luminous efficiency was rapidly decreased.

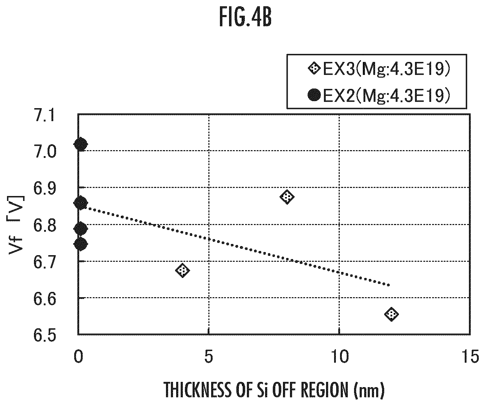

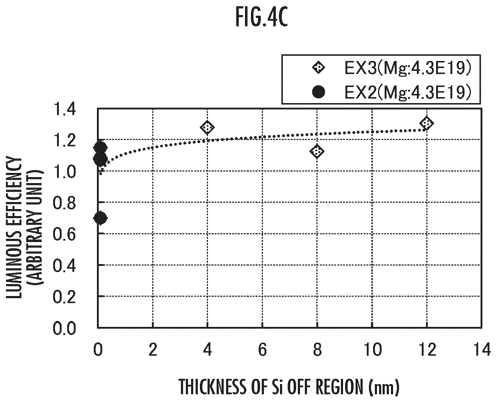

FIGS. 4B and 4C are graphs illustrating dependence of the forward voltage Vf and the luminous efficiency on the layer thickness of the Si co-doped off region, respectively. A dotted line indicates an approximated curve.

More specifically, the Si concentration in the structure 2 (EX2) and the structure 3 (EX3) was $3.7E18$ cm$^{-3}$. In addition, in the structure 3 (EX3), a case where Si-added off regions (that is, low concentration regions 15A and 15B) having a layer thickness of 4 nm or more were provided on both of the interface sides of the p-type $Al_{Y2}Ga_{1-Y2}N$ layer 15 was plotted.

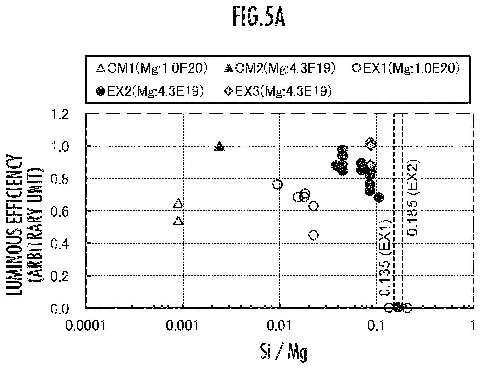

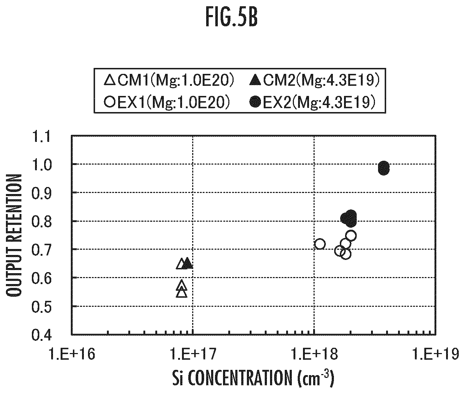

Referring to FIGS. 5A and 5B, the forward voltage Vf decreased linearly with respect to the layer thickness of the off region. On the other hand, it was able to be verified from the approximated curve that, when the Si off region having a size of 2 nm or more is present, the effect of improving the luminous efficiency appears. Accordingly, it is considered that the Si off region having a layer thickness of at least 2 nm may be present.

FIG. 5A is a graph where a relationship between the Si/Mg ratio (Si concentration/Mg concentration) of the p-type $Al_{Y2}Ga_{1-Y2}N$ layer 15 and the luminous efficiency (arbitrary unit) of the current supply start initial stage is plotted. In the structure 1, when the Si/Mg ratio was 0.135 or more, the luminous efficiency was rapidly decreased. In the structure 2, when the Si/Mg ratio was 0.185 or more, the luminous efficiency was rapidly decreased.

That is, it was found that the Si concentration in the p-type $Al_{Y2}Ga_{1-Y2}N$ layer 15 is preferably less than $9E18$ cm$^{-3}$ and more preferably less than $8E18$ cm$^{-3}$. In addition, it was found that the Si/Mg ratio in the p-type $Al_{Y2}Ga_{1-Y2}N$ layer 15 is preferably less than 0.185 and more preferably less than 0.135.

(2) Output Retention

FIG. 5B is a graph illustrating an output retention (@100 h) after 100 hours were elapsed from the initial stage with respect to the Si concentration of the p-type cladding layer 15. More specifically, an output retention that is a ratio of a change in the element output after 100 hours (hr) were elapsed from the start of current supply to the element is plotted with respect to the Si concentration in the p-type cladding layer 15. The current supply to the element was performed in a constant current (ACC) drive mode of causing a drive current of 450 mA to flow through the element.

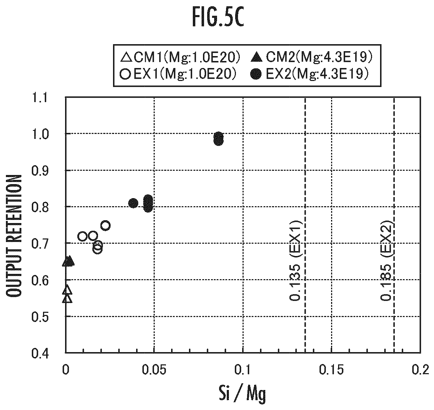

In addition, FIG. 5C is a graph illustrating the Si/Mg ratio (Si concentration/Mg concentration) of the p-type cladding layer 15 and the output retention. In both of the structure 1 (EX1) and the structure 2 (EX2), the output retention tended to be improved along with an increase in the Si concentration in the p-type cladding layer 15 and the Si/Mg ratio.

(Structure 1: EX1)

Regarding the Si concentration, referring to FIGS. 5B and 3, in the structure 1 (EX1: 1.0E20 cm$^{-3}$) where the Mg concentration in the p-type cladding layer 15 was high, the output retention was improved when the Si concentration was 1.1E18 cm$^{-3}$ or more. In addition, when the Si concentration was 9.0E18 cm$^{-3}$ or less, a decrease in output did not occur.

In addition, regarding the Si/Mg ratio, referring to FIGS. 5C and 3, the output retention was improved when the Si/Mg ratio was 0.009 or more. In addition, when the Si/Mg ratio was less than 0.135, a decrease in output did not occur.

(Structure 2: EX2)

Regarding the Si concentration, referring to FIGS. 5B and 3, in the structure 2 (EX2: 4.3E19 cm$^{-3}$) where the Mg concentration in the p-type cladding layer 15 was low, the output retention was improved when the Si concentration was 1.8E18 cm$^{-3}$ or more. In addition, when the Si concentration was 8.0E18 cm$^{-3}$ or less, a decrease in output did not occur.

In addition, regarding the Si/Mg ratio, referring to FIGS. 5C and 3, the output retention was improved when the Si/Mg ratio was 0.038 or more. In addition, when the Si/Mg ratio was less than 0.185, a decrease in output did not occur.

(Si/Mg ratio)

As illustrated in FIG. 5C, in both of the structure 1 and the structure 2, it is considered that the output retention increases substantially linearly along with an increase in the Si/Mg ratio, and the Si/Mg ratio is a predominant physical parameter that depends on the output retention. It is presumed that the Si/Mg ratio is in inverse proportion to the nitrogen defect concentration formed during undoping.

Specifically, when the Si/Mg ratios are 0.009 or more, 0.038 or more, and 0.064 or more, the output retentions are expected to be 0.7 or more, 0.8 or more, and 0.9 or more, respectively.

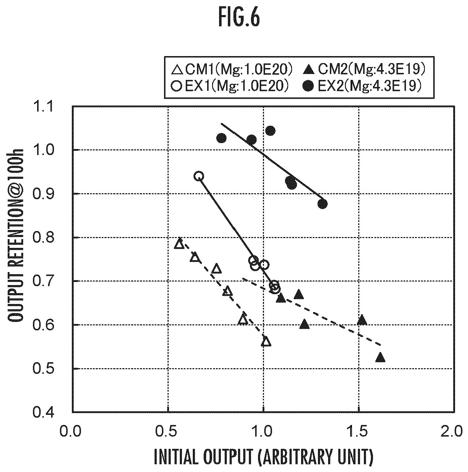

Even when Si is not co-doped (CM1 (Comparative Example 1) and CM2 (Comparative Example 2)), the output retention is higher in Comparative Example 2 (CM2) where the Mg concentration is low. The reason for this is presumed to be that, as described below (FIG. 6) in the structure 1 and Comparative Example 1 where the Mg concentration is high, the initial value of the nitrogen defect concentration that is considered to be a true cause for deterioration is excessively high.

Accordingly, by co-doping the p-type cladding layer 15 such that the Si/Mg ratio satisfies the following formulae, an ultraviolet LED having a high luminous efficiency and a favorable output retention (element lifetime) is realized.

$$0.009 \le (Si/Mg) < 0.185 \dots \text{Formula (1)}$$

In addition, it is more preferable that the Si/Mg ratio satisfies any one of the following formulae.

$$0.009 \le (Si/Mg) < 0.135 \dots \text{Formula (2)}$$

$$0.038 \le (Si/Mg) < 0.185 \dots \text{Formula (3)}$$

(Initial Output and Output Retention)

FIG. 6 is a graph illustrating an output retention (@100 h) with respect to a light output (arbitrary unit) of the current supply start initial stage in the elements obtained from the structure 1 (EX1), the structure 2 (EX2), Comparative Example 1 (CM1), and Comparative Example 2 (CM2).

It can be seen that, in the elements of Comparative Examples 1 and 2 (CM1, CM2), the output retention of the current supply start initial stage (~ 100 h) in a reliability test is low, and a decrease in light output is large. In addition, there is the trade-off relationship where, as the efficiency (that is, output) increases, the width of the decrease in output increases, and it is difficult to prepare an element with high output and high reliability.

On the other hand, it can be seen that, in the elements of the structures 1 and 2 (EX1, EX2) according to the present invention, the output retention of the current supply start initial stage (~ 100 h) is high, and a decrease in light output is suppressed. In addition, the output retention of the structure 2 (EX2) where the Mg concentration in the p-type cladding layer 15 is low is higher than that of the structure 1 (EX1).

It was verified that the output retention (@100 h) had a correlation with the long-term lifetime (1000 h). Accordingly, it was verified that the elements of the structures 1 and 2 (EX1, EX2) are also excellent in terms of long-term lifetime. According to the present invention, an element with high efficiency, high output, and high reliability can be realized.

[Estimation of Cause for Deterioration]

As the cause for the decrease in the output of the ultraviolet LED, generally, deterioration of the active layer, that is, a decrease in recombination probability (light emission transition probability) caused by an increase in point defects in the active layer is reported.

Based on the above-described finding and the results of the verification experiment performed for completing the present invention, the present inventors presumed that the mechanism for the deterioration of the ultraviolet LED is as follows. That is, it is presumed that, by doping the p-type $Al_{Y2}Ga_{1-Y2}N$ layer 15 with Si as a donor, the nitrogen defects in the p-type $Al_{Y2}Ga_{1-Y2}N$ layer 15 decreases. As a result, it is presumed that the amount of nitrogen defects diffused to the active layer decreases such that deterioration of the active layer is suppressed and a high output retention can be obtained.

(Co-Doping Impurity)

In the above-described embodiment, the case where Mg is used as the p-type impurity of the p-type $Al_{Y2}Ga_{1-Y2}N$ layer 15 that is the p-type cladding layer and Si is used as the co-doping impurity has been described, but the present invention is not limited thereto.

As described above, the mechanism of the present invention is presumed to be that the effect of reducing the nitrogen defects is exhibited due to the interaction between Mg as the acceptor impurity and Si as the donor impurity with which the p-type $Al_{Y2}Ga_{1-Y2}N$ layer 15 is doped. Therefore, any materials that can function as an acceptor and a donor in the p-type $Al_{Y2}Ga_{1-Y2}N$ layer 15 can be used without limitation.

Specifically, in addition to Mg that is the p-type impurity as the acceptor, Zn (zinc), Be (beryllium), C (carbon) or the like can be used. In addition, in addition to Si that is the n-type impurity (co-doping impurity) as the donor, Ge (germanium), Se (selenium), S (sulfur), O (oxygen), or the like can be used.

Accordingly, in general, when the p-type impurity concentration in the p-type $Al_{Y2}Ga_{1-Y2}N$ layer 15 is represented by Na and the n-type impurity concentration is represented by Nd, it is preferable that Nd/Na satisfies the following formula.

$$0.009 \leq (Nd/Na) < 0.185 \ ... \ Formula \ (4)$$

In addition, it is more preferable that Nd/Na satisfies any one of the following formulae.

$$0.009 \leq (Nd/Na) < 0.135 \ ... \ Formula \ (5)$$

$$0.038 \leq (Nd/Na) < 0.185 \ ... \ Formula \ (6)$$

Accordingly, by co-doping the p-type cladding layer 15 such that Nd/Na satisfies the above-described formulae, an ultraviolet LED having a high luminous efficiency and a favorable output retention (element lifetime) is realized.

As described above in detail, according to the present embodiment, it is possible to provide an ultraviolet LED having high efficiency, high output, reduced deterioration, and excellent element lifetime.

Description of Reference Numerals

10: ultraviolet light-emitting semiconductor element
11: substrate
12: n-type AlGaN layer
12A: first n-type $Al_{X1}Ga_{1-X1}N$ layer

12B: second n-type $Al_{X2}Ga_{1-X2}N$ layer
13: active layer
14: $Al_{Y1}Ga_{1-Y1}N$ layer
14A: AlN layer
14B: p-type AlN layer
15: p-type AlGaN layer
15A, 15B: low concentration region layer (off region)
15C: high concentration region layer
16: p-type GaN layer

**Claims**

1. An ultraviolet light-emitting semiconductor element comprising:

    a semiconductor structure layer where an n-type AlGaN layer, an active layer, an $Al_{Y1}Ga_{1-Y1}N$ layer ($0.8 \leq Y1 \leq 1.0$), and a p-type $Al_{Y2}Ga_{1-Y2}N$ layer ($0.5 \leq Y2 \leq 1.0$, $Y2 \leq Y1$) are epitaxially grown in this order,
    wherein the p-type $Al_{Y2}Ga_{1-Y2}N$ layer is co-doped with a p-type impurity as an acceptor and an n-type impurity as a donor, and a concentration ratio (Nd/Na) of a concentration (Nd) of the n-type impurity to a concentration (Na) of the p-type impurity satisfies $0.009 \leq (Nd/Na) < 0.185$,
    the $Al_{Y1}Ga_{1-Y1}N$ layer does not include the n-type impurity or a concentration of the n-type impurity is less than the concentration of the n-type impurity in the p-type $Al_{Y2}Ga_{1-Y2}N$ layer,
    the p-type $Al_{Y2}Ga_{1-Y2}N$ layer is a composition gradient layer where an Al composition Y2 decreases away from the $Al_{Y1}Ga_{1-Y1}N$ layer,
    the p-type $Al_{Y2}Ga_{1-Y2}N$ layer includes a high concentration region layer where a concentration of the n-type impurity is high and a low concentration region layer where a concentration of the n-type impurity is low, and
    the low concentration region layer is formed on at least any one interface side of the p-type $Al_{Y2}Ga_{1-Y2}N$ layer.

2. The ultraviolet light-emitting semiconductor element according to claim 1,
   wherein the low concentration region layer is formed on an interface side with the $Al_{Y1}Ga_{1-Y1}N$ layer.

3. The ultraviolet light-emitting semiconductor element according to claim 1,
   wherein the low concentration region layer is formed on both interface sides of the p-type $Al_{Y2}Ga_{1-Y2}N$ layer.

4. The ultraviolet light-emitting semiconductor element according to claim 1,
   wherein the concentration of the n-type impurity in the low concentration region layer is less than or equal to 1/2 of the concentration of the n-type impurity in the high concentration region layer.

5. The ultraviolet light-emitting semiconductor element according to claim 1,
wherein the concentration of the n-type impurity in the low concentration region layer is less than or equal to 1/10 of the concentration of the n-type impurity in the high concentration region layer.

6. The ultraviolet light-emitting semiconductor element according to claim 1,
wherein the p-type impurity is magnesium (Mg), and the n-type impurity is silicon (Si).

7. The ultraviolet light-emitting semiconductor element according to claim 6,
wherein Si/Mg that is the concentration ratio of the concentration of the n-type impurity to the concentration of the p-type impurity satisfies $0.009 \leq (Si/Mg) < 0.135$.

8. The ultraviolet light-emitting semiconductor element according to claim 6,
wherein the concentration ratio satisfies $0.038 \leq (Si/Mg) < 0.185$.

9. The ultraviolet light-emitting semiconductor element according to claim 1,
wherein the $Al_{Y1}Ga_{1-Y1}N$ layer includes Mg as an impurity.

10. The ultraviolet light-emitting semiconductor element according to claim 1,
wherein the $Al_{Y1}Ga_{1-Y1}N$ layer includes an undoped layer that is formed on the active layer and a Mg-doped layer that is formed on the undoped layer.

11. The ultraviolet light-emitting semiconductor element according to claim 1,
wherein the $Al_{Y1}Ga_{1-Y1}N$ layer is an AlN layer.

12. The ultraviolet light-emitting semiconductor element according to claim 1,

wherein the semiconductor structure layer is formed on a substrate, and
the substrate is a single-crystal AlN substrate.

13. The ultraviolet light-emitting semiconductor element according to claim 11,
wherein an Al composition on a side of the p-type $Al_{Y2}Ga_{1-Y2}N$ layer in contact with the $Al_{Y1}Ga_{1-Y1}N$ layer is in a range of 0.85 to 1.0, and an Al composition on another side of the p-type $Al_{Y2}Ga_{1-Y2}N$ layer is 0.50 to 0.85.

## FIG.1

FIG.2A

## FIG.2B

## FIG.3

| | Mg CONCENTRATION (cm$^{-3}$) | | Si CONCENTRATION (cm$^{-3}$) | Si/Mg | OFF REGION |
|---|---|---|---|---|---|
| | p-AlN | p-AlGaN | p-AlGaN | | |
| STRUCTURE 1 (EX1) | 4.5E19 | 1.0E20 | 8.1E18 ~ 1.9E19 | 0.001~0.207 | NONE |
| STRUCTURE 2 (EX2) | 4.5E19 | 4.3E19 | 9.0E16 ~ 8.0E18 | 0.002~0.185 | NONE |
| STRUCTURE 3 (EX3) | 4.5E19 | 4.3E19 | 9.0E16 ~ 8.0E18 | 0.002~0.185 | 4 - 12 nm |

# FIG.4A

# FIG.4B

FIG.4C

## FIG.5A

△CM1(Mg:1.0E20)  ▲CM2(Mg:4.3E19)  ○EX1(Mg:1.0E20)
●EX2(Mg:4.3E19)  ◇EX3(Mg:4.3E19)

# FIG.5B

# FIG.5C

## FIG.6

## INTERNATIONAL SEARCH REPORT

| International application No. |
|---|
| **PCT/JP2023/037781** |

**A. CLASSIFICATION OF SUBJECT MATTER**

*H01L 33/32*(2010.01)i; *H01L 33/06*(2010.01)i
FI:   H01L33/32; H01L33/06

According to International Patent Classification (IPC) or to both national classification and IPC

**B. FIELDS SEARCHED**

Minimum documentation searched (classification system followed by classification symbols)

H01L33/00-33/64; H01S5/00-5/50

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2019-160974 A (STANLEY ELECTRIC CO., LTD.) 19 September 2019 (2019-09-19) entire text, all drawings | 1-13 |
| A | JP 2019-68072 A (DOWA ELECTRONICS MATERIALS CO., LTD.) 25 April 2019 (2019-04-25) entire text, all drawings | 1-13 |
| A | US 2014/0097444 A1 (INDUSTRIAL TECHNOLOGY RESEARCH INSTITUTE) 10 April 2014 (2014-04-10) entire text, all drawings | 1-13 |
| P, A | JP 2022-167231 A (STANLEY ELECTRIC CO., LTD.) 04 November 2022 (2022-11-04) entire text, all drawings | 1-13 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **11 December 2023** | **19 December 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
**Information on patent family members**

International application No.

**PCT/JP2023/037781**

| Patent document cited in search report | | | Publication date (day/month/year) | Patent family member(s) | | | Publication date (day/month/year) |
|---|---|---|---|---|---|---|---|
| JP | 2019-160974 | A | 19 September 2019 | (Family: none) | | | |
| JP | 2019-68072 | A | 25 April 2019 | US | 2020/0235260 | A1 | |
| | | | | entire text, all drawings | | | |
| | | | | WO | 2019/069834 | A1 | |
| | | | | KR | 10-2020-0056395 | A | |
| | | | | CN | 111164768 | A | |
| US | 2014/0097444 | A1 | 10 April 2014 | TW | 201415661 | A | |
| JP | 2022-167231 | A | 04 November 2022 | (Family: none) | | | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019160974 A
- JP 2020057783 A
- JP 2019083221 A
- JP 2022003660 A

**Non-patent literature cited in the description**

- *J. Applmaru Physmaru*, 15 April 2004, vol. 95 (8)